# NEUE EUROPÄISCHE PATENTSCHRIFT

(11) **EP 1 540 748 B2**
(45) Veröffentlichungstag und Bekanntmachung des Hinweises auf die Entscheidung über den Einspruch: **20.01.2016**
(45) Hinweis auf die Patenterteilung: 20.04.2011
(21) Anmeldenummer: 02754112.7
(22) Anmeldetag: 10.09.2002
(51) Int. Cl.: H01L 43/06

(54) **MAGNETFELDSENSOR MIT EINEM HALLELEMENT**
MAGNETIC FIELD SENSOR COMPRISING A HALL ELEMENT
CAPTEUR DE CHAMP MAGNETIQUE POURVU D'UN ELEMENT A EFFET HALL

(43) Veröffentlichungstag der Anmeldung: 15.06.2005
(73) Patentinhaber: Melexis Technologies NV, 3980 Tessenderlo (BE)
(72) Erfinder: SCHOTT, Christian, CH-1167 Lussy-sur-Morges (CH); POPOVIC, Radivoje, CH-1025 St-Sulpice (CH); BESSE, Pierre-Andre, CH-1024 Ecublens (CH); SCHURIG, Enrico, CH-1022 Chavannes-près-Renens (CH)
(74) Vertreter: Falk, Urs
(86) Internationale Anmeldenummer: PCT/CH2002/000497
(87) Internationale Veröffentlichungsnummer: WO 2004/025742

(56) Entgegenhaltungen:
- EP-A- 0 362 493
- EP-A1- 0 204 135
- EP-B1- 1 438 755
- US-A- 5 572 058
- STEINER R ET AL: "Double-Hall sensor with self-compensated offset" INTERNATIONAL ELECTRON DEVICES MEETING, IEDM'97, WASHINGTON, DC, USA, 7. - 10. Dezember 1997, Seiten 911-914, XP000855940 ISBN: 0-7803-4100-7
- ROUMENIN C S: "Parallel-field Hall microsensors: an overview" SENSORS AND ACTUATORS A (PHYSICAL), Bd. A30, Nr. 1-2, Januar 1992 (1992-01), Seiten 77-87, XP000277696 ISSN: 0924-4247
- FALK U: "A symmetrical vertical Hall-effect device" SENSORS AND ACTUATORS A (PHYSICAL), Bd. A22, Nr. 1-3, März 1990 (1990-03), Seiten 751-753, XP000358526 ISSN: 0924-4247 in der Anmeldung erwähnt
- SCHURIG E ET AL: "CMOS integrated vertical Hall sensor with low offset" PROCEEDINGS EUROSENSORS XVI, 16TH EUROPEAN CONFERENCE ON SOLID-STATE TRANSDUCERS, PRAGUE, CZECH REPUBLIC, 15. - 18. September 2002, Seiten 868-871, XP002241233
- POPIVIC R.S.: 'The Vertical Hall-Effect Device' IEEE ELECTRON DEVICE LETTERS Bd. 5, Nr. 9, September 1984, Seiten 357 - 358
- POPOVIC R.S. ET AL: 'Hall Effect Devices', 1991, ADAM HILGER, BRISTOL - PHILADELPHIA - NEW YORK Seiten 158-159 - 202-203
- SCHURIG E. ET AL: 'A Vertical Hall Device in CMOS High-Voltage Technology' THE 11TH INTERNATIONAL CONFERENCE ON SOLID-STATE SENSORS AND ACTUATORS Juni 2001, Seiten 140 - 143

## Beschreibung

Die Erfindung betrifft einen Magnetfeldsensor mit einem symmetrischen vertikalen Hallelement der im Oberbegriff des Anspruchs 1 genannten Art.

Magnetfeldsensoren, die auf einem Hallelement basieren, werden seit Jahren in großen Stückzahlen gefertigt und in der Industrie, in Haushaltsgeräten und im Automobilbau als Positionsschalter oder für die Positionsmessung eingesetzt. Hallelemente, die in herkömmlicher IC-Technologie hergestellt sind, weisen alle Vorteile dieser Technologien auf, insbesondere die hohe Reproduzierbarkeit ihrer magnetischen und elektrischen Eigenschaften bei vergleichsweise geringen Kosten. Für die Messung der Komponente des Magnetfeldes, die senkrecht zur Chipoberfläche verläuft, werden sogenannte horizontale Hallelemente verwendet, während für die Messung der Komponenten des Magnetfeldes, die parallel zur Chipoberfläche verlaufen, sogenannte vertikale Hallelemente verwendet werden.

Ein herkömmliches Hallelement weist vier Kontakte auf, nämlich zwei Stromkontakte für die Zu- und Ableitung eines durch das Hallelement fließenden Stromes und zwei Spannungskontakte, um die von der zu messenden Magnetfeldkomponente erzeugte Hallspannung abzugreifen. Ein grundsätzliches Problem der Hallelemente ist, dass zwischen den beiden Spannungskontakten auch dann eine Spannung vorhanden ist, die sogenannte Offsetspannung, wenn kein Magnetfeld vorhanden ist. Um die Offsetspannung zu reduzieren, sind zwei Techniken entwickelt worden. Bei der einen Technik, die bei horizontalen Hallelementen angewendet wird, werden zwei horizontale Hallelemente verwendet, wobei die beiden Ströme, die durch die beiden Hallelemente fließen, einen Winkel von 90° einschließen. Bei der anderen, aus der US 4 037 150 bekannten Technik, die sich für symmetrische Hallelemente eignet, die elektrisch gegenüber einer Vertauschung der Strom- und Spannungskontakte invariant sind, werden die Strom- und Spannungskontakte elektrisch kommutiert. Diese Technik, die für horizontale Hallelemente entwickelt wurde, kann gemäß der US 5 057 890 auch für vertikale Hallelemente verwendet werden, bei denen die Lage und Größe der Strom- und Spannungskontakte mittels einer konformen Abbildung eines symmetrischen horizontalen Hallelementes berechnet wurden.

Die vorliegende Erfindung betrifft symmetrische vertikale Hallelemente, das sind Hallelemente, bei denen vier Kontakte, nämlich zwei innere und zwei äußere Kontakte, entlang einer Linie angeordnet sind. Die beiden inneren Kontakte sind typischerweise gleich groß und die beiden äußeren Kontakte sind gleich groß. Der Strom fließt jeweils von einem inneren Kontakt zu dem nicht benachbarten äußeren Kontakt, oder umgekehrt. Bei diesen symmetrischen vertikalen Hallelementen können die Strom- und Spannungskontakte wegen ihrer geometrischen Symmetrie vertauscht werden, das heißt elektrisch kommutiert werden, ohne dass sich die elektrischen und magnetischen Eigenschaften des Hallelementes ändern.

Symmetrische vertikale Hallelemente sind aus der oben zitierten US 5 057 890 und aus dem Artikel "A Symmetrical Vertical Hall-Effect Device", der in der Zeitschrift Sensors and Actuators, A21-A23 (1990), Seiten 751-753, publiziert wurde, bekannt, wurden in der Praxis aber bisher kaum eingesetzt, da sie bisher nur in einer speziellen Technologie hergestellt wurden, die es nicht erlaubte, neben dem Hallelement auch elektronische Schaltelemente auf dem gleichen Halbleiterchip zu integrieren.

Aus der US 5 572 058 ist ein vertikales Hallelement in Bipolartechnologie bekannt. Bei dieser Technologie ist das Hallelement vom Substrat isoliert, so dass neben dem Hallelement auch elektronische Elemente auf dem gleichen Halbleiterchip integriert werden können. Dieses vertikale Hallelement, das fünf entlang einer Geraden angeordnete Kontakte aufweist, nämlich einen Zentralkontakt und zwei äußere Kontakte, die als Stromkontakte dienen, und zwei Spannungskontakte, die zwischen dem Zentralkontakt und einem der äußeren Kontakte angeordnet sind, gehört aber nicht zur Gruppe der symmetrischen vertikalen Hallelemente, weil sich die elektrischen Eigenschaften des Hallelementes bei einer Vertauschung der Strom- und Spannungskontakte ändern.

Der Erfindung liegt die Aufgabe zugrunde, ein symmetrisches vertikales Hallelement zu entwickeln, das in einer n-leitenden Wanne einer CMOS-Technologie realisiert werden kann, bei dem die beiden Spannungskontakte potenzialmäßig etwa in der Mitte zwischen den Potenzialen der beiden Stromkontakte liegen und bei dem die Offsetspannung möglichst klein ist.

Die genannte Aufgabe wird erfindungsgemäß gelöst durch die Merkmale der Ansprüche 1 bis 6.

Bei dieser Aufgabe stellt sich einerseits das Problem, dass die mittels konformer Abbildungen berechneten Längen der Strom- und Spannungskontakte kleiner sind als die von der Technologie ermöglichten Mindestabmessungen. Der Grund liegt darin, dass die Tiefe der n-leitenden Wanne im Vergleich zur Distanz zwischen den äußeren Kanten der äußeren Kontakte sehr gering ist. Wenn die Strom- und Spannungskontakte gegenüber den berechneten idealen Werten entsprechend den Mindestanforderungen der Technologie vergrößert werden, dann liegen die beiden Spannungskontakte potenziaimäßig nicht mehr in der Mitte zwischen den Potenzialen der beiden Stromkontakte, die Offsetspannung wird vergleichsweise sehr groß und die Empfindlichkeit verkleinert sich stark. Wenn die beiden Spannungskontakte potenziatmäßig nicht mehr in der Mitte zwischen den Potenzialen der beiden Stromkontakte liegen, bedeutet dies, dass die Kommutierung der Strom- und Spannungskontakte nicht mehr sinnvoll angewendet werden kann. Zudem ist die Dotierung der n-leitenden Wanne nicht homogen. Dies führt dazu, dass erstens der größte Teil des Stromes direkt unterhalb der Oberfläche des Hallelementes fließt, typischerweise in einer Schicht von nur eins bis zwei Mikrometern Dicke, auch wenn die n-leitende Wanne eine Diffusionstiefe von mehreren Mikrometern aufweist, und dass zweitens auch die Theorie der konformen Abbildung nicht mehr anwendbar ist.

Die Erfindung geht aus von einem symmetrischen vertikalen Hallelement mit vier Kontakten, nämlich zwei inneren und zwei äußeren Kontakten, die an der Oberfläche eines Halbleiterchips entlang einer Linie angeordnet sind. Die beiden inneren Kontakte sind vorzugsweise gleich breit und die beiden äußeren Kontakte sind vorzugsweise gleich breit, wobei die Breite der Kontakte in Richtung der Geraden gemessen wird.

Das symmetrische vertikale Hallelement umfasst eine Wanne eines ersten Leitfähigkeitstyps, die in ein Substrat eines zweiten Leitfähigkeitstyps eingebettet ist. Die vier Kontakte kontaktieren die Wanne. Ein solches Hallelement mit vier Kontakten kann in elektrischer Hinsicht als eine durch vier Widerstände R₁ bis R₄ des Hallelementes gebildete Widerstandsbrücke angesehen werden. Beim Betrieb des Hallelementes als Magnetfeldsensor fließt jeweils ein Strom zwischen zwei Kontakten, die nicht benachbart sind. Das Hallelement wird in elektrischer Hinsicht dann als ideal angesehen, wenn die vier Widerstände R₁ bis R₄ den gleichen Wert aufweisen. In diesem Fall befinden sich bei der Speisung des Hallelementes über zwei Stromkontakte die als Spannungskontakte dienenden Kontakte beide auf dem gleichen elektrischen Potenzial, nämlich dem Potenzial der halben Speisespannung. Zudem ist dann die Spannung zwischen den Spannungskontakten, die sogenannte Offsetspannung, gleich null, d.h. die Offsetspannung verschwindet. Das Gleiche gilt auch, wenn die Rolle der Strom- und Spannungskontakte vertauscht wird.

Erfindungsgemäss wird vorgeschlagen, die vier Kontakte des Hallelementes derart anzuordnen, dass drei der vier Widerstände R₁, R₂ und R₃ aus geometrischen Gründen annähernd gleich groß sind. Der vierte Widerstand R₄, nämlich der elektrische Widerstand zwischen den beiden äußeren Kontakten, ist größer als die anderen Widerstände R₁, R₂ und R₃. Um die Widerstandsbrücke zu symmetrisieren, wird erfindungsgemäß weiter vorgeschlagen, einen weiteren Widerstand R₅ parallel zum Widerstand R₄ anzuordnen, dessen Wert so bestimmt ist, dass annähernd R₁ = R₂ = R₃ = R₄ || R₅ gilt. Der Widerstand R₅ ist beispielsweise ein externer Widerstand. Vorzugsweise ist der Widerstand R₅ jedoch in die Wanne des Hallelementes eingebettet oder als separate n-leitende Wanne realisiert. Im ersten Fall weist der Widerstand mindestens einen Kontakt auf, der die Wanne des Hallelementes kontaktiert und neben einem der beiden äußeren Kontakte auf der dem Rand der Wanne zugeordneten Seite angeordnet ist. Der Vorteil liegt darin, dass der Widerstand R₅ in diesem Fall den gleichen Temperaturkoeffizienten wie die Widerstände R₁, R₂, R₃ und R₄ aufweist, so dass die Widerstandsbrücke auch bei Temperaturschwankungen im Gleichgewicht bleibt.

Eine weitere Möglichkeit, die Widerstandsbrücke elektrisch abzugleichen, besteht darin, mindestens eine gegenüber der Wanne elektrisch isolierte Elektrode vorzusehen, wobei die mindestens eine Elektrode zwischen je zwei Kontakten angeordnet ist. Die mindestens eine Elektrode dient dazu, die elektrische Leitfähigkeit der Wanne im Gebiet unterhalb der Elektrode lokal zu erhöhen oder zu verkleinern.

Noch eine weitere Möglichkeit, die Widerstandsbrücke elektrisch abzugleichen, besteht darin, die elektrische Leitfähigkeit der Wanne im Gebiet zwischen zwei Kontakten lokal zu erhöhen oder zu verkleinern durch lokale Implantation von zusätzlichen oder weniger Ionen.

Noch eine weitere nicht den Gegenstand der Erfindung betreffende Möglichkeit, die Widerstandsbrücke elektrische abzugleichen, besteht darin, einen Magnetfeldsensor mit einem ersten Hallelement und einem zweiten Hallelement zu verwenden, die je zwei innere und zwei äußere entlang einer Geraden angeordnete Kontakte aufweisen, wobei vorzugsweise die beiden inneren Kontakte gleich breit sind und wobei vorzugsweise die beiden äußeren Kontakte gleich breit sind, wobei die Geraden der beiden Hallelemente parallel verlaufen und wobei die Kontakte der beiden Hallelemente über Leiterbahnen derart verdrahtet sind, dass ihre Hallspannungen gleichsinnig sind und sich ihre Offsetspannungen weitgehend kompensieren, so dass die insgesamt resultierende Offsetspannung annähernd verschwindet.

Nachfolgend werden Ausführungsbeispiele der Erfindung anhand der Zeichnung näher erläutert. Die Figuren sind nicht maßstäblich gezeichnet.

Es zeigen:
- Fig. 1: ein symmetrisches vertikales Hallelement im Querschnitt,
- Fig. 2: das symmetrische vertikale Hallelement in Aufsicht,
- Fig. 3: ein elektrisches Ersatzschaltbild für das symmetrische vertikale Hallelement,
- Fig. 4: ein symmetrisches vertikales Hallelement mit einem integrierten Widerstand,
- Fig. 5: ein symmetrisches vertikales Hallelement mit zwei integrierten Widerständen,
- Fig. 6: ein symmetrisches vertikales Hallelement mit zusätzlichen Elektroden,
- Fig. 7: eine Maske, die bei der Implantation von Ionen für die Bildung einer n-leitenden Wanne verwendet wird, und
- Fig. 8, 9: zwei antiparallel geschaltete Hallelemente.

Die Fig. 1 und 2 zeigen ein symmetrisches vertikales Hallelement 1 im Querschnitt bzw. in Aufsicht. Das in einer CMOS-Technologie hergestellte Hallelement 1 besteht vorzugsweise aus einer Wanne 2 eines ersten Leitfähigkeitstyps, die in ein Substrat 3 aus Silizium eines zweiten Leitfähigkeitstyps eingebettet ist. Das Hallelement 1 weist an der Oberfläche vier Kontakte 4 - 7 auf, nämlich zwei innere Kontakte 5 und 6, sowie zwei äußere Kontakte 4 und 7. Die Kontakte 4 - 7 sind entlang einer Geraden 8 (Fig. 2) angeordnet. Vorzugsweise sind die beiden inneren Kontakte 5 und 6 in Richtung der Geraden 8 gesehen gleich breit und die beiden äußeren Kontakte 4 und 7 gleich breit. Die Lage und Grösse der Wanne 2 und der Kontakte 4 - 7 ist dann symmetrisch bezüglich einer Ebene 9, die senkrecht zur Geraden 8 und in der Mitte zwischen den beiden inneren Kontakten 5 und 6 verläuft. (Aus technologischen Gründen ist es sinnvoll, die beiden inneren Kontakte 5 und 6 gleich breit und die beiden äußeren Kontakte 4 und 7 gleich breit zu machen, es ist aber nicht zwingend erforderlich.)

Weil bei Silizium die Beweglichkeit der Elektronen größer ist als die Beweglichkeit der Löcher, wird für das Hallelement 1 mit Vorteil eine n-leitende Wanne und nicht eine p-leitende Wanne verwendet. Für das Hallelement 1 könnte zwar eine p-leitende Wanne verwendet werden, allerdings wäre dann die Empfindlichkeit des Magnetfeldsensors deutlich kleiner.

Die Tiefe t der Wanne 2 beträgt typischerweise etwa 5 µm. Da die Dotierung der Wanne 2 nicht homogen ist, sondern mit zunehmender Tiefe exponentiell abnimmt, fließt der größte Teil des Stromes unterhalb der Oberfläche des Hallelementes 1 in einer dünnen Schicht von typischerweise 1 - 2 µm Dicke. Die für die elektrischen und magnetischen Eigenschaften des Hallelementes 1 effektive Tiefe t_{eff} der Wanne 2 beträgt somit nur etwa 1 - 2 µm. Die Länge L des Hallelementes 1 ist gegeben durch die Länge der Wanne 2. Sie entspricht im wesentlichen der Distanz zwischen den äußeren Kanten 10 bzw. 11 der äußeren Kontakte 4 und 7. Die Länge L ist groß im Vergleich zur Tiefe t bzw. zur effektiven Tiefe t_{eff}. Die elektrischen Eigenschaften des Hallelementes 1 können durch eine aus vier Widerständen R₁ bis R₄ gebildete Widerstandsbrücke dargestellt werden. Des einfacheren Verständnisses wegen sind in der Fig. 1 die zwischen je zwei Kontakten herrschenden Widerstände durch ein Widerstandssymbol R₁ bis R₄ und eine Linie dargestellt, die die dem Widerstand entsprechenden Kontakte verbindet.

Die Fig. 3 zeigt das elektrische Schaltbild der durch die vier Widerstände R₁ bis R₄ des Hallelementes 1 gebildeten Widerstandsbrücke. Beim Betrieb des Hallelementes 1 als Magnetfeldsensor fließt jeweils ein Strom zwischen zwei Kontakten, die nicht benachbart sind, beispielsweise zwischen den Kontakten 4 und 6 oder zwischen den Kontakten 5 und 7. Das Hallelement 1 wird in elektrischer Hinsicht dann als ideal angesehen, wenn die vier Widerstände R₁ bis R₄ den gleichen Wert aufweisen. In diesem Fall befinden sich bei der Speisung des Hallelementes 1 über die Kontakte 4 und 6 die als Spannungskontakte dienenden Kontakte 5 und 7 beide auf dem gleichen elektrischen Potenzial, nämlich dem Potenzial der halben Speisespannung. Zudem ist dann die Spannung zwischen den Spannungskontakten gleich null, d.h. die Offsetspannung verschwindet. Das Gleiche gilt, wenn das Hallelement 1 über die Kontakte 5 und 7 gespeist wird und die Kontakte 4 und 6 als Spannungskontakte dienen.

Die Widerstände R₁ und R₃ sind aus geometrischen Gründen gleich groß. Der Widerstand R₂ kann durch Vergrößern oder Verkleinern des Abstandes zwischen den inneren Kontakten 5 und 6 verändert werden. Durch geeignete Wahl der Lage und Größe der Kontakte 4 - 7 kann man also erreichen, dass annähernd R₁ = R₂ = R₃ gilt. Zudem gilt, dass der Widerstand R₄ größer als die anderen Widerstände R₁, R₂ und R₃ ist. Um die Widerstandsbrücke zu symmetrisieren, wird erfindungsgemäß vorgeschlagen, einen weiteren Widerstand R₅ parallel zum Widerstand R₄ anzuordnen, dessen Wert so bestimmt ist, dass annähernd R₁ = R₂ = R₃ = R₄ || R₅ gilt. Der Widerstand R₅ ist beispielsweise ein externer Widerstand. Vorzugsweise ist der Widerstand R₅ jedoch in die n-leitende Wanne 2 des Hallelementes 1 eingebettet oder als separate n-leitende Wanne realisiert. Der Vorteil liegt darin, dass der Widerstand R₅ in diesem Fall den gleichen Temperaturkoeffizienten wie die Widerstände R₁, R₂, R₃ und R₄ aufweist, so dass die Widerstandsbrücke auch bei Temperaturschwankungen im Gleichgewicht bleibt.

Die Fig. 4 und 5 zeigen zwei Beispiele, bei denen der Widerstand R₅ in die Wanne 2 des Hallelementes 1 eingebettet ist. Des einfacheren Verständnisses wegen sind die zwischen jeweils zwei Kontakten herrschenden Widerstände wiederum durch ein Widerstandssymbol und eine die entsprechenden Kontakte verbindende Linie dargestellt. Beim Beispiel gemäß der Fig. 4 ist neben dem Kontakt 4 ein weiterer Kontakt 12 angeordnet, der über eine nur schematisch dargestellte Leiterbahn 13 mit dem Kontakt 7 verbunden ist. Beim Beispiel gemäß der Fig. 5 sind neben dem Kontakt 4 ein weiterer Kontakt 12 und neben dem Kontakt 7 ein weiterer Kontakt 14 angeordnet, wobei die beiden zusätzlichen Kontakte 12 und 14 über eine wiederum nur schematisch dargestellte Leiterbahn 13 verbunden sind. Bei diesem Beispiel ist also der Widerstand R₅ nicht durch einen einzigen Widerstand, sondern durch zwei Widerstände mit dem Wert ½R₅ realisiert.

Der Miniaturisierung des Hallelementes sind dadurch Grenzen gesetzt, dass zwischen den beiden inneren Kontakten 5 und 6 ein durch die Technologie bedingter Mindestabstand einzuhalten ist. Dieser Mindestabstand liegt heutzutage im Bereich von etwa 0.8 µm. Der Widerstand R₂ kann also einen gewissen, durch die verwendete Technologie vorgegebenen Wert, nicht unterschreiten. Im folgenden werden weitere Beispiele erläutert, wie die Widerstände R₁ bis R₃ erhöht oder verkleinert werden können.

Beim Beispiel gemäß der Fig. 6 sind zwischen den Kontakten 4 - 7 drei Elektroden 15 - 17 angeordnet, die z.B. wie die Gateelektroden eines MOSFET's aus Polysilizium realisiert sind. Die Elektroden 15-17 sind von der n-leitenden Wanne z.B. durch eine dünne Oxidschicht getrennt und somit gegenüber der n-leitenden Wanne 2 elektrisch isoliert. Beim Betrieb des Hallelementes 1 werden die Elektroden 15-17 gegenüber der n-leitenden Wanne 2 je mit einer vorbestimmten Spannung vorgespannt. Die Elektroden 15 und 17 werden mit der gleichen Spannung vorgespannt, während die Elektrode 16 mit einer Spannung von umgekehrter Polarität vorgespannt wird. Die Vorspannung einer Elektrode gegenüber der n-leitenden Wanne 2 bewirkt, dass abhängig vom Vorzeichen der Vorspannung die Ladungsträgerdichte im Gebiet unterhalb der Elektrode entweder erhöht oder verkleinert wird. Um die Ladungsträgerdichte zu erhöhen, muss die Vorspannung der Elektrode invers zum Typ der Ladungsträger der Wanne 2 sein. Wenn die Wanne 2 n-leitend ist, dann muss die Vorspannung der Elektrode also positiv gegenüber dem Potenzial der Wanne 2 sein. Um die Ladungsträgerdichte zu verkleinern, muss die Vorspannung der Elektrode gleich dem Typ der Ladungsträger der Wanne 2 sein. Wenn die Wanne 2 n-leitend ist, dann muss die Vorspannung der Elektrode in diesem Fall also negativ gegenüber dem Potenzial der Wanne 2 sein.

Es ist auch möglich, anstelle von drei Elektroden 15, 16 und 17 nur eine einzige Elektrode vorzusehen, nämlich die Elektrode 16 zwischen den inneren Kontakten 5 und 6, oder nur die beiden Elektroden 15 und 17, die je zwischen einem inneren und einem äußeren Kontakt angeordnet sind. Zudern ist es möglich, beim Beispiel gemäß der Fig. 4 eine weitere Elektrode vorzusehen, die zwischen den Kontakten 4 und 12 angeordnet ist, oder beim Beispiel gemäß der Fig. 5 zwei weitere Elektroden vorzusehen, die zwischen den Kontakten 4 und 12 bzw. 7 und 14 angeordnet sind. Durch Wahl von Größe und Vorzeichen der an die einzelnen Elektroden angelegten Vorspannungen können die Widerstände R₁ bis R₅ innerhalb gewisser Grenzen verändert werden. Es sind deshalb elektronische Spannungsquellen vorgesehen, die im gleichen Halbleiterchip wie das Hallelement 1 realisiert sind, wobei die an die einzelnen Elektroden anzulegenden Vorspannungen in einem Kalibrierungsverfahren einmal so bestimmt werden, dass die durch die Widerstände R₁ bis R₅ gebildete Widerstandsbrücke optimal abgeglichen ist.

Eine weitere Möglichkeit, die Widerstände R₁ bis R₃ bei vorgegebener Lage und Größe der Kontakte 4 - 7 zu verkleinern oder zu erhöhen, besteht darin, die Ladungsträgerdichte mittels lokaler Implantation von zusätzlichen oder von weniger Ionen zu erhöhen bzw. verkleinern. Diese Möglichkeit wird anhand der Fig. 7 näher erläutert. Die Kontakte 4 bis 7 sind durch Flächen dargestellt, die mit einer gestrichelten Linie 18 umrandet sind. Bei der Bildung der n-leitenden Wanne 2 wird für die Ionenimplantation eine Maske 19 verwendet, die nicht eine einzige, der Größe der Wanne 2 entsprechende Öffnung 20 aufweist, sondern eine Öffnung 20, die lokale Inseln 21 aufweist, die einen Teil der Öffnung 20 abdecken, so dass die Dotierung der n-leitenden Wanne 2 lokal variiert. Die Abmessungen der Inseln 21 sind so klein gewählt, dass sich die durch die Inseln 21 getrennten Gebiete bei der auf die Implantation folgenden Diffusion zu der n-leitenden Wanne 2 verbinden. Die Dotierung der Wanne 2 im Gebiet zwischen den beiden inneren Kontakten 5 und 6 ist somit verschieden von der Dotierung der Wanne 2 in den Gebieten zwischen einem inneren Kontakt und einem benachbarten äußeren Kontakt.

Die Fig. 8 und 9 illustrieren eine weitere nicht den Gegenstand der Erfindung betreffende Möglichkeit, die durch die Widerstände R₁ bis R₄ gebildete Widerstandsbrücke weitgehend abzugleichen, nämlich durch eine Parallelschaltung von zwei Hall-elementen 1 und 1', die parallel zueinander angeordnet sind, so dass sie die gleiche Komponente des Magnetfeldes messen. Die Richtungen der durch die beiden Hallelemente 1 und 1' fließenden Ströme sind symbolisch durch Pfeile dargestellt, die vom Kontakt, wo der Strom eingespeist wird, zum Kontakt, wo der Strom abgeleitet wird, zeigen. Die Kontakte 4 - 7 des ersten Hallelementes 1 und die Kontakte 4' - 7' des zweiten Hallelementes 1' sind über schematisch dargestellte Leiterbahnen 13 paarweise verdrahtet. Die Verdrahtung muss zwei Kriterien erfüllen, die nachfolgend beschrieben sind. Erstens müssen die durch das Magnetfeld erzeugten Hallspannungen der beiden Hallelemente 1 und 1' gleichsinnig sein, sonst "sieht" der Magnetfeldsensor das Magnetfeld nicht. Wenn die beiden Stromkontakte durch einen Pfeil verbunden werden, der die Richtung des Stromes angibt, dann befindet sich jeweils ein Spannungskontakt auf der linken Seite des Pfeils und ein Spannungskontakt auf der rechten Seite des Pfeils. Gleichsinnig bedeutet nun, dass die beiden Spannungskontakte der beiden Hallelemente 1 und 1', die auf der linken Seite des entsprechenden Pfeils liegen, verbunden werden müssen, und dass die beiden Spannungskontakte der beiden Hallelemente 1 und 1', die auf der rechten Seite des entsprechenden Pfeils liegen, verbunden werden müssen. Wenn die beiden Hallelemente 1 und 1' nicht verdrahtet wären, dann würde beim ersten Hallelement 1 der eine der beiden Spannungskontakte 5 und 7 ein höheres Potenzial als der andere Spannungskontakt führen, weil ja der Widerstand R₄ größer als die anderen Widerstände R₁, R₂ und R₃ ist. Ebenso würde beim zweiten Hallelement 1' der eine der beiden Spannungskontakte 4' und 6' ein höheres Potenzial als der andere Spannungskontakt führen, weil auch hier der Widerstand R₄' größer als die anderen Widerstände R₁', R₂' und R₃' ist. Beim Beispiel der Fig. 8 führt - bei der in der Fig. 8 dargestellten Richtung des Stromes - der Spannungskontakt 7 des ersten Hallelementes 1 das höhere Potenzial als der Spannungskontakt 5. Beim zweiten Hallelement 1' führt der Spannungskontakt 4' das höhere Potenzial als der Spannungskontakt 6'. Die Spannungskontakte 7, 5, 4' und 6' der beiden Hallelemente 1 und 1' sind nun zweitens derart zu verdrahten, dass der Spannungskontakt 7 des ersten Hallelementes 1, der das höhere Potenzial führt, mit dem Spannungskontakt 6' des zweiten Hallelementes 1', der das kleinere Potenzial führt, verbunden ist. Wegen dieser Verdrahtung teilen sich die durch die beiden Hallelemente 1 und 1' fließenden Ströme so auf, dass die zwischen den Spannungskontakten 7 und 5 des ersten Hallelementes 1 bei verschwindendem Magnetfeld anliegende Spannung, die sogenannte Offsetspannung, viel kleiner ist als sie ohne Zuschaltung des zweiten Hallelementes 1' in der beschriebenen Weise wäre. Bei dem in der Fig. 8 dargestellten Beispiel sind die Kontakte 4 - 7 des ersten Hallelementes 1 und die Kontakte 4' - 7' des zweiten Hallelementes 1' also paarweise wie folgt verdrahtet: der Kontakt 4 mit dem Kontakt 7', der Kontakt 5 mit dem Kontakt 4', der Kontakt 6 mit dem Kontakt 5' und der Kontakte 7 mit dem Kontakt 6', wobei die Ströme in beiden Hallelementen 1 und 1' jeweils von einem inneren Kontakt zu dem nicht benachbarten äußeren Kontakt, aber in entgegengesetzter Richtung, fließen.

Bei dem in der Fig. 9 dargestellten Beispiel fließen die Ströme in gleicher Richtung, beim ersten Hallelement 1 von einem inneren Kontakt zu dem nicht benachbarten äußeren Kontakt, beim zweiten Hallelement 1' jedoch von einem äußeren Kontakt zu dem nicht benachbarten inneren Kontakt. Die Kontakte 4 - 7 des ersten Hallelementes 1 und die Kontakte 4' - 7' des zweiten Hallelementes 1' sind paarweise wie folgt verdrahtet: der Kontakt 4 mit dem Kontakt 5', der Kontakt 5 mit dem Kontakt 6', der Kontakt 6 mit dem Kontakt 7' und der Kontakt 7 mit dem Kontakt 4', so dass die beiden oben angegebenen Kriterien erfüllt sind.

Bei den bisher beschriebenen Ausführungsbeispielen ist das symmetrische vertikale Hallelement 1 in die n-leitende Wanne 2 eingebettet, die durch Implantation von Ionen und nachfolgende Diffusion in einem p-leitenden Substrat erzeugt wurde. Eine solche Technologie wird allgemein als CMOS Technologie bezeichnet. Anstelle einer CMOS Technologie kann aber auch eine Bipolartechnologie verwendet werden, bei der das symmetrische vertikale Hallelement 1 in ein isoliertes Gebiet in einer Epitaxieschicht eingebettet ist. Auch ein solches isoliertes Gebiet kann als n-Wanne bezeichnet werden. Während die in Bipolartechnologie hergestellte n-Wanne homogen mit Fremdatomen dotiert ist, ist die Dotierung der in CMOS Technologie hergestellten n-Wanne nicht homogen.

## Patentansprüche

1. Magnetfeldsensor, mit einem Hallelement (1), das zwei innere und zwei äußere entlang einer Geraden (8) angeordnete Kontakte (4-7) aufweist, die an der Oberfläche einer Wanne (2) eines ersten Leitfähigkeitstyps, die in ein Substrat (3) eines zweiten Leitfähigkeitstyps eingebettet ist, angeordnet sind, wobei die beiden inneren Kontakte (5, 6) gleich breit sind und wobei die beiden äußeren Kontakte (4, 7) gleich breit sind, wobei ein erster der beiden äußeren Kontakte (4, 7) und ein erster der beiden inneren Kontakte (5, 6), die nicht benachbart sind, als Stromkontakte dienen, die mit einem Strom beaufschlagbar sind, und wobei der zweite der beiden äußeren Kontakte (4, 7) und der zweite der beiden inneren Kontakte (5, 6) als Spannungskontakte dienen, an denen eine Hallspannung abgreifbar ist, **dadurch gekennzeichnet, dass** die vier Kontakte (4-7) des Hallelementes derart angeordnet sind, dass die drei Widerstände R₁ , R₂ und R₃ annähernd gleich groß sind, wobei R₁ den Widerstand zwischen dem ersten Kontakt (4) und dem zweiten Kontakt (5), R₂ den Widerstand zwischen dem zweiten Kontakt (5) und dem dritten Kontakt (6) und R₃ den Widerstand zwischen dem dritten Kontakt (6) und dem vierten Kontakt (7) bezeichnet, und dass die beiden äußeren Kontakte (4, 7) durch einen zusätzlichen Widerstand verbunden sind, der einen Widerstandswert R₅ aufweist, der so bemessen ist, dass annähernd R₁ = R₂ = R₃ = R₄ R₅ gilt, wobei R₄ den Widerstand zwischen R₄∥R₅, (Druckfehler korrigieren) dem ersten Kontakt (4) und dem vierten Kontakt (7) bezeichnet.

2. Magnetfeldsensor nach Anspruch 1, **dadurch gekennzeichnet, dass** der zusätzliche Widerstand durch eine Wanne des ersten Leitfähigkeitstyps gebildet ist.

3. Magnetfeldsensor nach Anspruch 1, **dadurch gekennzeichnet, dass** der zusätzliche Widerstand in der Wanne (2) des Hallelementes (1) gebildet ist und einen Kontakt (12) aufweist, der neben einem der beiden äußeren Kontakte (4) des Hallelementes (1) auf der dem Rand der Wanne (2) zugewandten Seite angeordnet ist.

4. Magnetfeldsensor nach Anspruch 1, **dadurch gekennzeichnet, dass** der zusätzliche Widerstand in der Wanne (2) des Hallelementes (1) gebildet ist und zwei Kontakte (12, 14) aufweist, die je neben einem der äußeren Kontakte (4, 7) des Hallelementes (1) auf der dem Rand der Wanne (2) zugewandten Seite angeordnet sind, wobei die zwei Kontakte (12, 14) des Widerstands über eine Leiterbahn (13) verbunden sind.

5. Magnetfeldsensor nach einem der Ansprüche 1 bis 4, **dadurch gekennzeichnet, dass** mindestens eine gegenüber der Wanne (2) elektrisch isolierte Elektrode (15; 16, 17) zwischen zwei Kontakten (4-7) angeordnet ist.

6. Magnetfeldsensor nach einem der Ansprüche 1 bis 5, **dadurch gekennzeichnet, dass** die Dotierung der Wanne (2) im Gebiet zwischen den beiden inneren Kontakten (5, 6) verschieden ist von der Dotierung der Wanne (2) in den Gebieten zwischen einem inneren Kontakt (5, 6) und einem äußeren Kontakt (4, 7).

## Claims

1. Magnetic field sensor, with a Hall element (1) that has two inner and two outer contacts (4-7) arranged along a straight line (8), which contacts (4-7) are arranged on the surface of a well (2) of a first conductivity type that is embedded in a substrate (3) of a second conductivity type, wherein the two inner contacts (5, 6) are the same width and wherein the two outer contacts (4, 7) are the same width, wherein a first of said two outer contacts (4, 7) and a first of said two inner contacts (5, 6) which are not adjacent contacts act as current contacts to which a current can be applied, and wherein the second of said two outer contacts (4, 7) and the second of said two inner contacts (5, 6) act as voltage contacts for tapping a Hall voltage, **characterised in that** the four contacts (4-7) of the Hall element (1) are arranged such that the three resistances R₁, R₂ and R₃ are approximately the same size, wherein R₁ denotes the resistance between the first contact (4) and the second contact (5), R₂ denotes the resistance between the second contact (5) and the third contact (6) and R₃ denotes the resistance between the third contact (6) and the fourth contact (7), and **in that** the two outer contacts (4, 7) are connected via an additional resistor that has a resistance R₅ that is selected such that approximately R₁ = R₂ = R₃ = R₄∥R₅ wherein R₄ denotes the resistance between the first contact (1) and the fourth contact (7).

2. Magnetic field sensor according to claim 1, **characterised in that** the additional resistor is formed by a well of the first conductivity type.

3. Magnetic field sensor according to claim 1, **characterised in that** the additional resistor is formed in the well (2) of the Hall element (1) and has a contact (12) arranged next to one of the two outer contacts (4) of the Hall element (1) on the side facing the edge of the well (2).

4. Magnetic field sensor according to claim 1, **characterised in that** the additional resistor is formed in the well (2) of the Hall element (1) and has two contacts (12, 14) that are each arranged next to one of the outer contacts (4; 7) of the Hall element (1) on a side facing an adjacent edge of the well (2), the two contacts (12, 14) of the resistor connected via a conductor path (13).

5. Magnetic field sensor according to claims 1 to 4, **characterised in that** at least one electrode (15; 16; 17) electrically insulated from the well (2) is arranged between two contacts (4-7).

6. Magnetic field sensor according to claims 1 to 5, **characterised in that** the doping of the well (2) in the area between the two inner contacts (5, 6) is different to the doping of the well (2) in the areas between an inner contact (5; 6) and an outer contact (4; 7).

## Revendications

1. Capteur de champ magnétique, comprenant un élément de Hall (1) qui a deux contacts intérieurs et deux contacts extérieurs (4 - 7) agencés le long d'une ligne droite (8), dans lequel les contacts (4-7) sont disposés sur la surface d'une cuve (2) d'un premier type de conductivité et qui est noyée dans un substrat (3) d'un second type de conductivité, dans lequel les deux contacts intérieurs (5, 6) sont de la même largeur et dans lequel les deux contacts extérieurs (4, 7) sont de la même largeur, dans lequel un premier contact parmi les deux contacts extérieurs (4, 7) et un premier contact parmi les deux contacts intérieurs (5, 6) qui ne sont pas des contacts adjacents agissent comme contacts de courant sur lequel un courant peut être appliqué, et dans lequel le second desdits deux contacts extérieurs (4, 7) et le second desdits deux contacts intérieurs (5, 6) agissent comme contacts de tension pour la saisie d'une tension de Hall, **caractérisé en ce que** les quatre contacts (4 - 7) de l'élément de Hall (1) sont agencés de telle sorte que les trois résistances R₁, R₂ et R₃ sont approximativement de même taille, dans lequel R₁ désigne la résistance entre le premier contact (4) et le second contact (5), R₂ désigne la résistance entre le second contact (5) et le troisième contact (6) et R₃ désigne la résistance entre le troisième contact (6) et le quatrième contact (7), et **en ce que** les deux contacts extérieurs (4, 7) sont connectés par une résistance supplémentaire qui a une résistance R₅ qui est sélectionnée de telle sorte que l'équation R₁ = R₂ = R₃ = R₄∥R₅ est valable, équation dans laquelle R₄ désigne la résistance entre le premier contact (1) et le quatrième contact (7).

2. Capteur de champ magnétique selon la revendication 1, **caractérisé en ce que** la résistance supplémentaire est formée par une cuve du premier type de conductivité.

3. Capteur de champ magnétique selon la revendication 1, **caractérisé en ce que** la résistance supplémentaire est formée dans la cuve (2) de l'élément Hall (1) et comporte un contact (12) qui est disposé à côté d'un des deux contacts (4) extérieurs (4, 7) de l'élément Hall (1) sur le côté orienté vers le bord de la cuve (2).

4. Capteur de champ magnétique selon la revendication 1, **caractérisé en ce que** la résistance supplémentaire est formée dans la cuve (2) de l'élément Hall (1) et comporte deux contacts (12, 14) qui sont disposés chacun près d'un des contacts extérieurs (4, 7) sur le côté orienté vers le bord de la cuve (2), ces deux contacts (12, 14) étant connectés par une piste conductrice (13).

5. Capteur de champ magnétique selon une des revendications 1 à 4, **caractérisé en ce qu'**au moins une électrode (15; 16, 17) isolée électriquement de la cuve (2) est disposée entre deux contacts (4-7).

6. Capteur de champ magnétique selon une des revendications 1 à 5, **caractérisé en ce que** le dopage de la cuve (2) dans la zone située entre les deux contacts intérieurs (5, 6) est différent du dopage de la cuve (2) dans les zones situées entre un contact intérieur (5, 6) et un contact extérieur (4, 7).
